# FASCICULE DE BREVET EUROPEEN

(11) **EP 3 542 390 B1**
(45) Date de publication et mention de la délivrance du brevet: **30.09.2020**
(21) Numéro de dépôt: 17801750.5
(22) Date de dépôt: 02.11.2017
(51) Int. Cl.: H01J 37/32, C23C 16/455, C23C 16/54

(54) **UNITÉ DE TRAITEMENT POUR INSTALLATION DE TRAITEMENT DE SURFACE D'UN SUBSTRAT EN MOUVEMENT, INSTALLATION ET PROCÉDÉ DE MISE EN OEUVRE CORRESPONDANTS**
BEARBEITUNGSEINHEIT FÜR EINE BEARBEITUNGSANLAGE DER OBERFLÄCHE EINES BEWEGLICHEN SUBSTRATS, BEARBEITUNGSANLAGE UND IMPLEMENTIERUNGSVERFAHREN DAFÜR
TREATING UNIT FOR A TREATMENT INSTALLATION OF THE SURFACE OF A MOVING SUBSTRATE, CORRESPONDING INSTALLATION AND IMPLEMENTING METHOD

(30) Priorité: 16.11.2016 FR 1661074
(43) Date de publication de la demande: 25.09.2019
(73) Titulaire: Coating Plasma Innovation, 13710 Fuveau (FR)
(72) Inventeur: VALLADE, Julien, 13530 Trets (FR); PFISTER, Cédric, 13790 Rousset (FR)
(74) Mandataire: Schmidt, Martin Peter
(86) Numéro de dépôt international: PCT/FR2017/053005
(87) Numéro de publication internationale: WO 2018/091797

(56) Documents cités:
- US-A1- 2004 187 783
- US-A1- 2005 001 527
- US-A1- 2009 165 715
- US-A1- 2011 244 140

## Description

### Domaine technique de l'invention

L'invention concerne une unité de traitement, destinée à équiper une installation de traitement de surface d'un substrat en mouvement. Elle vise plus précisément une telle installation dans laquelle le substrat est soumis à un plasma généré dans un mélange gazeux, ce qui conduit à la modification de l'état de surface de ce substrat et/ou à la formation d'un dépôt sur la surface précitée. L'invention concerne en particulier une telle installation, qui peut être mise en œuvre à une pression proche de la pression atmosphérique, et qui est appropriée pour le traitement de surface continu de films polymères en bobines (procédé de type « roll-to-roll »).

### Etat de la technique

On connait déjà des installations, visant à modifier et à améliorer les propriétés de surface d'un substrat au moyen d'un plasma. De telles propriétés d'intérêt peuvent être, par exemple, l'énergie de surface ou encore les propriétés d'adhésion de ce substrat. Les substrats visés par l'invention peuvent être notamment des isolants tels que des films polymères, des films métalliques, du papier ou du tissu.

Dans la mise en oeuvre de ces installations connues, en vue du dépôt d'une couche solide mince sur la surface d'un substrat, cette surface est soumise à un plasma créé par une décharge électrique dans un gaz. Par ailleurs, simultanément ou postérieurement, le substrat ainsi traité est exposé à un mélange gazeux qui contient un composé gazeux actif, susceptible d'induire le dépôt de ce film solide mince.

Il est également connu de mettre en oeuvre de manière continue des procédés de traitement d'un substrat au moyen d'une décharge électrique dans un mélange gazeux, dans lesquels le substrat est mis en mouvement à des vitesses pouvant aller jusqu'à plusieurs centaines de mètres par minute, typiquement au sein d'une chambre. Cette dernière contient, outre les électrodes nécessaires à la création de la décharge, un dispositif d'injection du mélange gazeux actif, ainsi que des moyens d'évacuation des effluents gazeux.

L'invention vise plus particulièrement une installation de traitement par plasma, opérant sensiblement à pression atmosphérique. Dans ce type d'installations, la circulation des gaz dans la zone de plasma est critique pour obtenir une homogénéité de traitement satisfaisante. Cette homogénéité de traitement est en particulier critique selon la largeur du substrat, à savoir selon la direction perpendiculaire à la direction de défilement de ce substrat.

Une installation de traitement, telle que visée par l'invention, comprend tout d'abord des moyens d'injection d'un gaz plasmagène, éventuellement associé à un gaz auxiliaire tel un dopant. L'état de la technique fait intervenir des moyens d'injection de natures et de formes variées, tels des tubes percés de trous ou encore des fentes. Une telle installation comprend en outre au moins une électrode destinée à coopérer avec une contre électrode pour générer une décharge électrique. Dans le cas où plusieurs électrodes sont prévues, elles sont disposées de façon successive selon le sens de défilement du substrat.

Pour concentrer les dopants au voisinage de chaque électrode, WO-A-2016/128259 décrit une tête de traitement équipée de tubes d'injection percés de trous, ainsi que de plusieurs électrodes. Le gaz plasmagène est injecté en arrière des électrodes, alors que des gaz dopants sont injectés au voisinage de la surface du substrat. Cette configuration apporte effectivement une amélioration, par rapport à la solution faisant intervenir une injection commune de gaz plasmagène et de dopants en arrière des électrodes. En revanche, l'espace entre l'injection et l'électrode est générateur de turbulences et de zones de recirculation des gaz. Par conséquent, les dopants ont tendance à se re-disperser dans le volume de la tête précitée, au lieu d'être concentrés entre l'électrode et le substrat. De plus, dans le cas d'un dépôt plasma, ces recirculations favorisent la formation de poudres. Par ailleurs lorsque la puissance est augmentée, le plasma s'étend jusqu'aux bords verticaux de l'électrode, ce qui entraine une perte d'efficacité. En effet, à cet endroit spécifique, le plasma ne peut servir à traiter le substrat.

Dans l'installation décrite dans JP-A-2016/062812, l'injection du gaz plasmagène est réalisée par l'intermédiaire d'une fente, alors qu'une des parois de l'injection est formée d'une plaque isolante sur laquelle est posée une électrode. Cette configuration permet de réduire, dans une certaine mesure, les turbulences et les phénomènes de recirculation des gaz. En revanche, notamment dans le cas d'un substrat souple défilant sur un rouleau support, on constate que le traitement plasma, mis en oeuvre au moyen de cette installation, est difficile à contrôler.

US 2005/001527 décrit un appareil de traitement plasma, dans lequel le gaz de traitement est admis en partie haute, puis s'écoule le long d'une chambre intermédiaire selon une direction perpendiculaire à l'avancée du substrat, avant d'être injecté en direction de ce substrat. Cet appareil est équipé d'électrodes mutuellement adjacentes, entre lesquelles est inséré un matériau diélectrique.

Compte tenu de ce qui précède, un objectif de la présente invention est de remédier, au moins partiellement, aux inconvénients de l'art antérieur évoqués ci-dessus.

Un autre objectif de l'invention est de proposer une unité de traitement qui permet à l'installation qui en est équipée d'assurer une bonne homogénéité de traitement selon la largeur du substrat, à savoir perpendiculairement à la direction de défilement de ce substrat.

Un autre objectif de l'invention est de proposer une telle unité, dont la géométrie permet de concentrer d'éventuels dopants, au voisinage de la surface du substrat défilant.

Un autre objectif de l'invention est de proposer une telle unité, permettant de maximiser l'effet du traitement plasma pour pouvoir traiter les substrats souples à grande vitesse.

Un autre objectif de l'invention est de proposer une telle unité qui, tout en assurant un traitement de surface fiable d'un substrat, notamment de type "roll to roll", à une pression proche de la pression atmosphérique, permet de réduire significativement la quantité de gaz dopants consommée, par rapport à l'art antérieur.

Un autre objectif de l'invention est de proposer une telle unité qui confère, à l'installation qui en est équipée, un pilotage commode et une mise en œuvre relativement simple.

### Objets de l'invention

Selon l'invention, au moins un des objectifs ci-dessus est atteint au moyen d'une unité de traitement (1A) pour une installation de traitement de surface d'un substrat (SUB) en mouvement, telle que définie dans la revendication 1.

Une installation de traitement plasma comprend une ou plusieurs unités de traitement conforme(s) à l'invention, ainsi qu'un rouleau support sur lequel vient se plaquer le substrat à traiter. La ou chaque unité assure l'injection des gaz, ainsi que la génération du plasma. Le substrat passe entre le rouleau support et chaque unité, en vue de son traitement.

Conformément à l'invention, le fait de prévoir une chambre intermédiaire telle que définie dans la revendication 1 est tout particulièrement avantageux. En service, le gaz de traitement s'écoule tout d'abord dans l'organe d'admission, avant de pénétrer dans la chambre intermédiaire, laquelle assure cette fonction d'homogénéisation. Au sein de cette chambre, la direction principale de ce gaz subit plusieurs changements. Par ailleurs, la section de passage de ce gaz subit des variations, dont notamment une augmentation en vue transversale. Par conséquent, cela confère notamment une distribution homogène selon une dimension transversale, à savoir sur toute la largeur de traitement du substrat.

On notera tout d'abord que la chambre intermédiaire d'homogénéisation, conforme à l'invention, assure des performances nettement supérieures à celles du dispositif décrit dans JP-A-2016/062812. En effet, ce document prévoit d'intercaler une chambre présentant une forme particulièrement simple, globalement parallélépipédique, située entre un conduit d'entrée et une fente de sortie. Dans ces conditions, l'homogénéisation de la distribution est certes meilleure que dans le cas d'une injection directe, ne faisant pas appel à une telle chambre. En revanche, des différences entre les vitesses de sortie du gaz persistent entre le centre et les extrémités de la fente précitée, car les formes de cette chambre induisent des recirculations du gaz intempestives.

On notera en outre que US 2005/001527 est muet quant à une éventuelle variation de la section de passage de la région aval, en vue transversale. Par ailleurs, dans ce document, le tronçon aval est de section constante, de sorte que cette section ne diminue pas au voisinage de la sortie. Enfin la direction d'écoulement du gaz est globalement invariante, à savoir verticale, tout au long de la chambre intermédiaire décrite dans ce document.

Selon l'invention, au moins un des objectifs ci-dessus est également atteint au moyen d'une unité de traitement (1A) pour une installation de traitement de surface d'un substrat (SUB) en mouvement, cette installation comprenant en outre
- un support (2) pour le substrat,
- une contre électrode, notamment confondue avec le support ;
cette unité de traitement comprenant
- au moins un logement (50) de réception d'au moins une électrode adaptée pour coopérer avec ladite contre électrode pour créer une décharge électrique ;
- des premiers moyens (20, 21, 22) d'injection pour l'injection d'un premier gaz, ou gaz de traitement, vers ledit support, ce premier gaz comprenant au moins un gaz plasmagène ; ces premiers moyens d'injection comprenant un organe d'injection (21) du premier gaz, débouchant en regard du support,
- des deuxièmes moyens (30, 31, 32) d'injection pour l'injection d'un deuxième gaz, ou gaz auxiliaire, vers ledit support, ces deuxièmes moyens d'injection comprenant un organe d'injection (31) du deuxième gaz, débouchant en regard du support,
- l'organe d'injection (31) du deuxième gaz étant incliné en direction de l'organe d'injection (21) du premier gaz, en vue longitudinale.

Selon d'autres caractéristiques de l'invention :
- la chambre intermédiaire est symétrique par rapport un axe médian (A1) de l'unité (1A), en vue transversale (YY), la région amont (24) étant formée par deux conduites amont (25, 26) s'étendant de part et d'autre dudit axe médian, la région aval (27) étant formée par deux conduites aval (28, 29) s'étendant de part et d'autre dudit axe médian et prolongeant chacune une conduite amont respective.
- la chambre intermédiaire (22) est formée autour d'un noyau central (23) possédant une face amont (231) tournée vers l'organe d'admission (20), ainsi que des faces latérales (232) s'étendant à partir de la face amont (231), le noyau central étant notamment de forme triangulaire.
- l'organe d'injection (21) s'étend sur sensiblement toute la largeur de l'unité, en étant notamment formée par une fente unique.
- cette unité comprend en outre des deuxièmes moyens d'injection (30, 31, 32) pour l'injection d'un deuxième gaz vers ledit support, ces deuxièmes moyens d'injection comprenant un organe d'injection (31) du deuxième gaz, débouchant en regard du support, l'organe d'injection du deuxième gaz étant incliné en direction de l'organe d'injection (21) du premier gaz, en vue longitudinale.
- les deuxièmes moyens d'injection (30, 31, 32) comprennent en outre un organe d'admission (30) du deuxième gaz, destiné à être mise en communication avec une source d'alimentation en ce deuxième gaz, ainsi qu'une chambre intermédiaire (32) reliant les deux organes respectifs d'admission et d'injection,
cette chambre intermédiaire comportant
- une région amont (36), s'étendant à partir de l'organe d'admission (30), le premier gaz s'écoulant en service selon une deuxième direction dans cette région amont, ladite deuxième direction étant oblique, notamment perpendiculaire, par rapport à ladite première direction, la section de passage du premier gaz augmentant depuis l'entrée (36E) vers la sortie (36S) de la région amont en vue longitudinale et/ou en vue transversale,
- ainsi qu'une région aval (39), s'étendant entre la région amont (26) et l'organe d'injection (31), le premier gaz s'écoulant en service selon une troisième direction dans cette région aval, ladite troisième direction étant oblique, notamment perpendiculaire, par rapport à ladite deuxième direction, la section de passage du premier gaz augmentant depuis l'entrée (39E) vers la sortie (39S) de la région aval, en vue transversale, mais la section de passage du premier gaz diminuant au voisinage de la sortie (39S) de la région aval, en vue longitudinale.
- les axes principaux, respectivement de l'organe d'injection du premier gaz et de l'organe d'injection du deuxième gaz, forment un angle (α31) compris entre 20° et 70°, notamment entre 40° et 50°, en particulier voisin de 45°.
- les débouchés, respectivement de l'organe d'injection du premier gaz et de l'organe d'injection du deuxième gaz, sont séparés d'une distance (d3) inférieure à 10 millimètres, en particulier inférieure à 4 millimètres.
- les débouchés, respectivement du logement et de l'organe d'injection du second gaz, sont séparés d'une distance (d2) inférieure à 20 millimètres, en particulier inférieure à 15 millimètres.
- l'unité comprend des bords inférieurs respectivement amont et aval de forme arrondie, dont le rayon de courbure est compris entre 0.5 millimètre et 10 millimètres.
- l'électrode est reçue à ajustement serré dans son logement, cette électrode et ces parois comprenant des bords de forme arrondie, dont le rayon de courbure est compris entre 0.5 millimètre et 10 millimètres.
- en vue longitudinale (XX), l'organe d'admission (20) est placé en avant, ou en aval, par rapport à l'organe d'injection (21), en référence au défilement du substrat en service.
- cette unité est réalisée sous forme d'un bloc massif dont la paroi inférieure, en regard du support, est sensiblement pleine, la distance (d1) entre cette paroi inférieure et le support étant sensiblement constante selon la direction longitudinale, cette distance étant notamment inférieure à 5 millimètres, en particulier inférieure à 2 millimètres.
- l'unité comprend plusieurs éléments constitutifs distincts, notamment usinés, ces éléments étant mutuellement solidarisés par des moyens de fixation permanente, notamment par collage ou soudage.
- l'unité comprend un unique élément constitutif, cette unité étant dépourvue de joints d'assemblage, cette unité étant en particulier réalisée par prototypage rapide, stéréolithographie ou impression en trois dimensions.

Ces caractéristiques additionnelles peuvent être mises en oeuvre avec l'un ou l'autre des objets principaux ci-dessus, individuellement ou en combinaisons quelconques, techniquement compatibles.

L'invention a également pour objet une installation de traitement de surface d'un substrat (SUB) en mouvement, telle que définie dans la revendication 14.

De façon avantageuse, ledit ensemble comprend plusieurs unités de traitement, ces unités étant mises en communication avec au moins deux sources de gaz de traitement différents et/ou deux sources de gaz auxiliaires différents.

Selon d'autres caractéristiques de l'invention :
- ces plusieurs unités de traitement sont disposées les unes derrière les autres, selon la direction de défilement du substrat.
- ces plusieurs unités de traitement sont disposées les unes à côté des autres, selon la direction de défilement du substrat.
- les unités de traitement disposées les unes à côté des autres sont équipées de moyens de fixation mutuelle, en particulier de moyens de fixation amovible, par exemple du type tenon et mortaise.

L'invention a également pour objet, défini dans la revendication 15, un procédé de mise en oeuvre d'une installation de traitement de surface telle que définie ci-dessus.

De façon avantageuse on fait s'écouler le premier gaz à la sortie de l'organe d'injection à une vitesse comprise entre 1 m/s et 20 m/s, en particulier à la même vitesse que la vitesse de défilement du substrat.

### Description des figures

L'invention va être décrite ci-après, en référence aux dessins annexés, donnés uniquement à titre d'exemples non limitatifs, dans lesquels :
La figure 1 est une vue en perspective, illustrant une installation de traitement de surface équipée d'unités de traitement conformes à l'invention.
La figure 2 est une vue de face illustrant, à bien plus grande échelle, l'une de ces unités de traitement conformes à l'invention.
La figure 3 est une vue en coupe transversale, illustrant plus particulièrement la chambre d'homogénéisation, dont est équipée l'unité de traitement de la figure 2.
La figure 4 est une vue en perspective, illustrant la chambre d'homogénéisation de la figure 3.
La figure 5 est une vue de face, analogue à la figure 2, illustrant une unité de traitement conforme à une variante de réalisation de l'invention.
La figure 6 est une vue de dessus, illustrant de manière schématique une succession d'unités de traitement disposées les unes à côté des autres, selon la direction de défilement du substrat.

Les références numériques suivantes sont utilisées dans la présente description :

| | |
|---|---|
| 1A - 1D Blocs | 2 Tambour |
| f2 Rotation de 2 | D2 Diamètre de 2 |
| L2 Longueur de 2 | SUB Substrat |
| S1 S2 Déplacement de SUB | |
| 3 Nip (rouleau presseur) | F3 Rotation de 3 |
| D3 Diamètre de 3 | L3 Longueur de 3 |
| 11 16 Parois supérieure inférieure de 1 | 12 13 Parois amont aval de 1 |
| 14 15 Parois latérales de 1 | d1 distance 16 - 2 |
| 17, 17' Bords de 1 | |
| 20 Organe d'admission | 21 Organe d'injection |
| d20 Distance 20 - 21 | A21 Axe de 21 |
| 22 Chambre | 23 Noyau central |
| 231 Face amont de 23 | 232 Faces latérales de 23 |
| 24 Région amont de 22 | 25, 26 Conduites de 24 |
| 25E, 26E Entrées de 25, 26 | 25S, 26S Sorties de 25, 26 |
| 27 Région aval de 22 | 28, 29 Conduites de 27 |
| 28E, 29E Entrées de 28, 29 | 28S, 29S Sorties de 28, 29 |
| 30 Organe d'admission | 31 Organe d'injection |
| A31 Axe de 31 | α31 Angle A21 A31 |
| 32 Chambre | 36 Conduite amont de 32 |
| 36E, 36S Entrée Sortie de 36 | 39 Conduite aval de 32 |
| 39E, 39S Entrée Sortie de 39 | |
| 50 Logement | 50' Bords de 50 |
| d2 Distance 31 - 50 | d3 Distance 21 - 31 |
| 4 Capot de confinement | 41 Paroi supérieure de 4 |
| 42 43 Parois amont aval de 4 | 44 45 Parois latérales de 4 |
| 120 Organe d'admission | 121 Organe d'injection |
| 130 Organe d'admission | 131 Organe d'injection |
| 104 Capot de confinement | V103 Volume intérieur de 103 |
| α31 Angle A21 A31 | |
| 1a-1n Unités de traitement (figure 6) | 14a-14n,15a-15n Parois latérales |
| 18a-18n Tenons | 19a-19n Mortaises |
| 20a-20n Organes d'admission | |

### Description détaillée

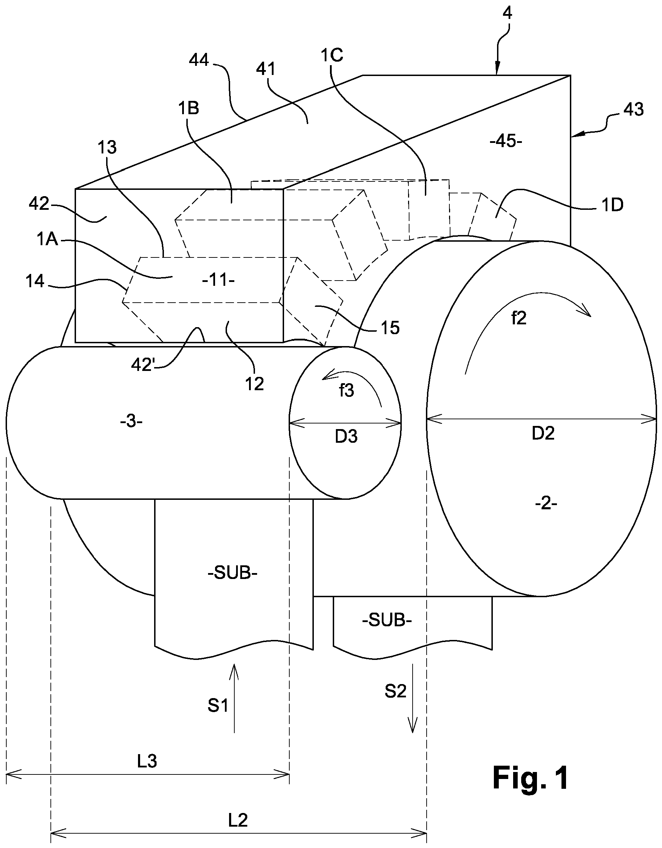

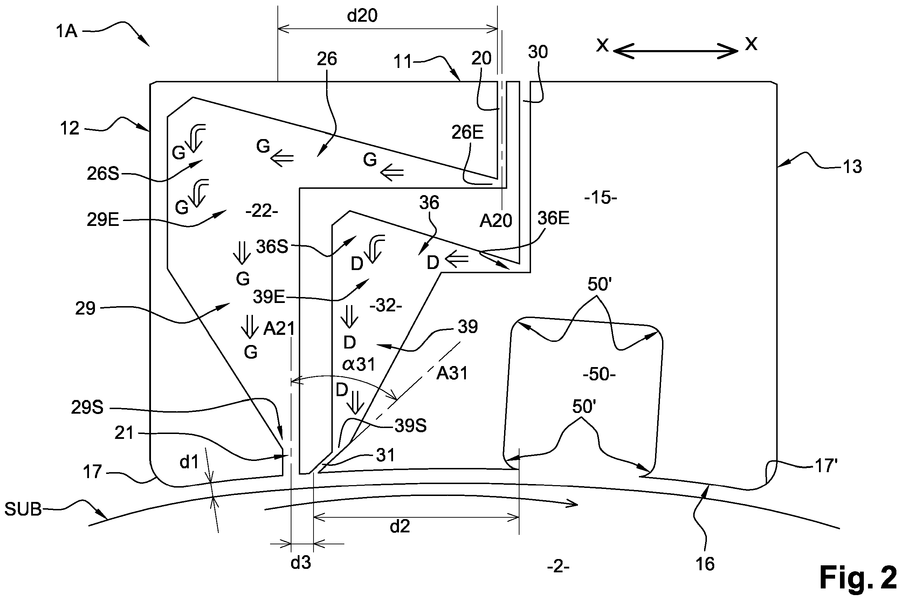

La figure 1 illustre une installation de traitement de surface par plasma, équipée d'un ensemble de traitement formé par plusieurs unités de traitement 1A à 1D conformes à l'invention, lesquelles sont représentées plus en détail aux figures 2 et suivantes. Cette installation comprend essentiellement, outre les unités précitées, un tambour 2 formant support pour un substrat SUB, un rouleau presseur 3, ainsi qu'un capot de confinement 4 recouvrant ces blocs.

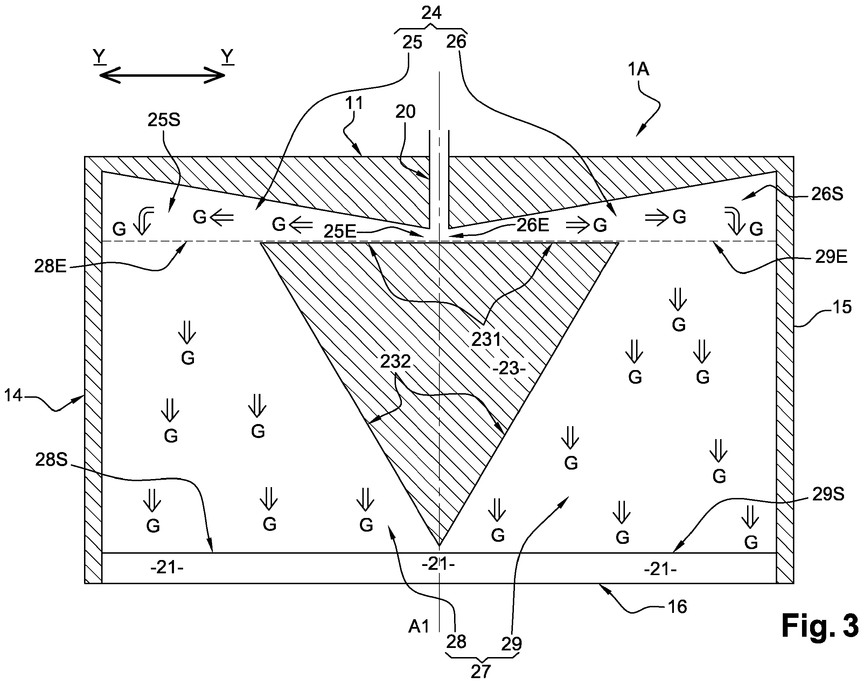

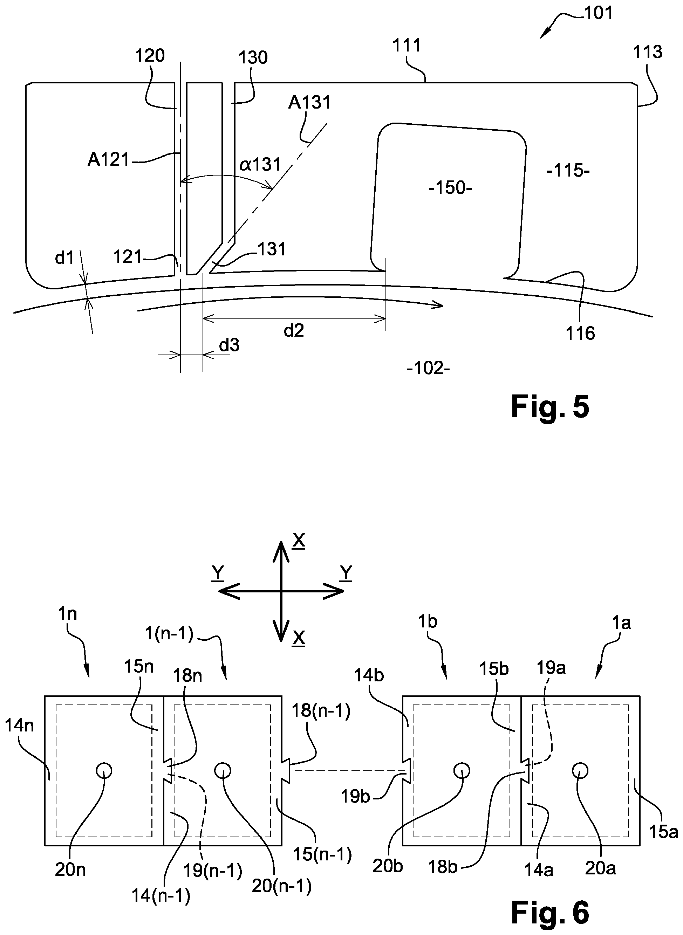

Le tambour 2 de type connu en soi est mis en rotation, en service, selon la direction matérialisée par la flèche f2. On note D2 son diamètre et L2 sa dimension longitudinale. Ce tambour forme un support pour le substrat SUB, destiné à circuler selon les flèches S1 et S2, de sorte à être traité conformément à l'invention. Dans ce qui suit, la direction longitudinale correspond à la direction de défilement du substrat, alors que la direction transversale ou latérale est perpendiculaire à cette direction de défilement. Par ailleurs, par convention, une vue de face, encore dénommée vue longitudinale désigne une vue dans laquelle la direction longitudinale est incluse dans le plan de la feuille, comme sur les figures 2 et 5. Une vue de côté, encore dénommée vue transversale, désigne une vue dans laquelle la direction longitudinale s'étend d'arrière en avant de la feuille, comme sur la figure 3.

Dans le présent mode de réalisation, le tambour 2 assure une fonction supplémentaire de contre électrode, laquelle coopère avec des électrodes qui seront décrites dans ce qui suit. A cette fin, ce tambour est avantageusement recouvert d'une couche isolante, de manière connue en soi. Cependant, cette contre électrode peut être formée par un autre composant de l'installation. A titre d'exemple, le substrat est fait de polypropylène, alors que son épaisseur est comprise entre 20 et 100 micromètres.

Dans sa partie amont, en référence au déplacement du substrat, le tambour 2 est avantageusement associé au rouleau presseur 3 (appelé par l'homme du métier aussi "Nip"), également de type connu en soi. Comme cela sera décrit plus en détail dans ce qui suit, le rouleau secondaire 3 est mis en rotation, en service, selon la direction matérialisée par la flèche f3. Cela permet de presser le substrat contre le tambour, de manière à éviter la formation d'une couche d'air entre ce substrat et ce tambour. Ceci permet d'éviter tout défaut local de traitement sur le substrat. On note D3 son diamètre, lequel est bien inférieur à celui D2 du tambour, ainsi que L3 sa dimension longitudinale, laquelle est par exemple voisine de celle L2 du tambour.

Les différentes unités de traitement, lesquelles sont avantageusement identiques, sont réalisées sous forme de blocs massifs 1A à 1D. On va maintenant décrire la structure de l'un 1A de ces blocs, sachant que celle des autres blocs est similaire.

Le bloc 1A possède une paroi supérieure 11 et des parois périphériques, formées par des parois parallèles respectivement avant ou amont 12, et arrière ou aval 13, ainsi que des parois latérales parallèles 14 et 15. A titre d'exemple sa première dimension, définie par la distance entre les parois 14 et 15, est typiquement comprise entre 1 000 mm et 2 000 mm, étant entendu qu'elle peut présenter des valeurs nettement inférieures, par exemple jusqu'à 20 mm. A titre d'exemple sa deuxième dimension, définie par la distance entre les parois 12 et 13, est comprise entre 50 mm et 200 mm. Chaque bloc est fixé par tout moyen approprié, de préférence de façon amovible, sur les parois latérales du capot 4, qui va être décrit dans ce qui suit.

Ce bloc 1A possède en outre une paroi inférieure 16, tournée vers le tambour 2. Cette paroi 16, qui est sensiblement pleine, délimite le débouché pour des premiers et seconds moyens d'injection, respectivement pour un premier et un second gaz. Elle est en outre creusée d'un logement, en vue de la réception d'au moins une électrode. Ces moyens d'injection, ainsi que ce logement et cette électrode, vont maintenant être décrits plus en détail.

Cette paroi inférieure 16 est séparée du tambour 2 d'une distance notée d1, laquelle est avantageusement constante selon la direction longitudinale de défilement. A cet effet, cette paroi inférieure présente un rayon de courbure R16, lequel est égal à R16=R2+d1, où R2 est le rayon du tambour, soit D2/2, et d1 est la distance précitée. Dans le cas où le substrat défile sur un support plan, tel une plaque, le dessous du bloc est également plan et s'étend parallèlement à la face en regard du support. Cette distance d1 est de préférence inférieure à 5 millimètres, en particulier inférieure à 2 millimètres, notamment voisine de 1 millimètre.

Le fait de prévoir une distance (d1) constante permet d'éviter toute recirculation substantielle des gaz de traitement, dans l'espace ménagé entre le bloc et la surface du substrat. Cette caractéristique permet de plus de remédier, dans une mesure significative, aux inconvénients liés à JP-A-2016/062812, présentés ci-dessus. En effet, selon l'enseignement de ce document, l'espace entre la plaque isolante et le substrat varie et, par conséquent, la densité de puissance du plasma varie en fonction de la position. Le traitement plasma, mis en oeuvre au moyen de la présente invention, est donc sensiblement plus aisé à contrôler que dans l'installation de JP-A-2016/062812.

La jonction entre la paroi amont 12 et la paroi inférieure 16 du bloc définit un premier bord, dénommé bord amont 17. De façon analogue, la jonction entre la paroi aval 13 et la paroi inférieure 16 définit un second bord, dénommé bord aval 17'. De manière avantageuse, ces bords 17 et 17' sont arrondis, avec un rayon de courbure typiquement compris entre 0.5 mm (millimètres) et 10 mm. Cette forme arrondie permet, entre autres, d'éviter les recirculations de gaz.

Les premiers moyens d'injection comprennent essentiellement un organe d'admission 20, un organe d'injection 21, ainsi qu'une chambre intermédiaire 22. Chacun de ces organes 20 et 21 présente une section de passage sensiblement constante, entre ses extrémités amont et aval. De façon avantageuse, la section de passage du gaz dans l'organe d'injection est supérieure à la section de passage dans l'organe d'admission. La section totale d'admission est par exemple comprise entre 0.07 et 1.2 cm², alors que la section totale d'injection est par exemple comprise entre 0.3 et 2 cm². Le rapport entre la section totale d'injection et la section totale d'admission est donc par exemple compris entre 1.5 et 10.

En vue longitudinale selon l'axe XX, l'organe d'admission 20 est placé en avant, ou en aval, par rapport à l'organe d'injection 21, en référence au défilement du substrat en service. Soit R20 le rayon du cercle passant par le centre du tambour 2 et l'organe d'admission, on note d20 la distance entre ces deux organes 20 et 21, selon une droite perpendiculaire à R20. Cette distance est par exemple comprise entre 0 mm et 150 mm. Ce décalage entre les deux organes 20 et 21 permet d'augmenter le volume de la chambre 22, afin d'avoir une meilleure homogénéisation.

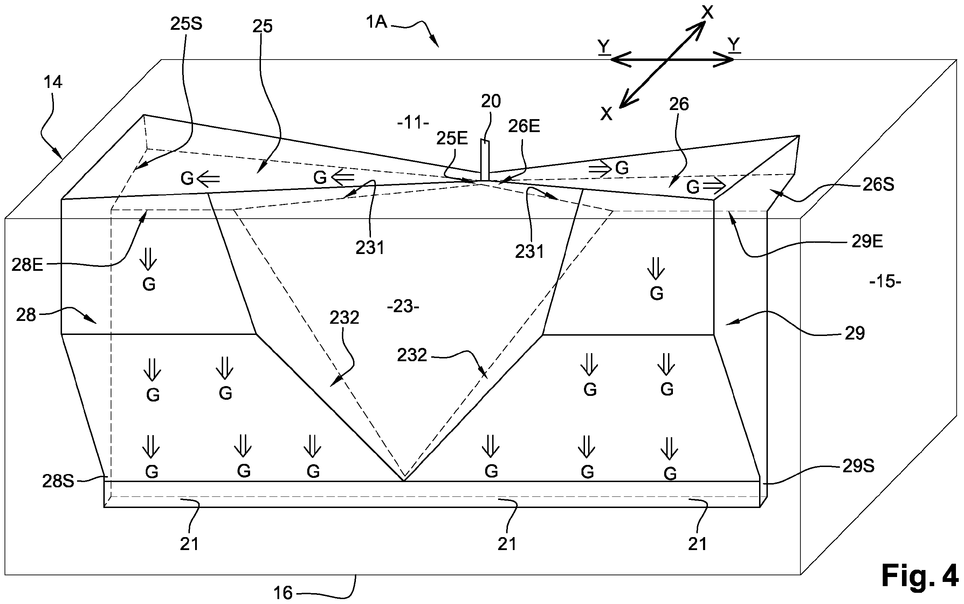

De façon typique, comme montré sur la perspective de la figure 4, l'organe d'admission peut prendre la forme d'un passage tubulaire unique 20, de faible longueur. Dans le cas d'un bloc de grande largeur, on peut prévoir quelques passages tubulaires d'admission, régulièrement répartis. Par ailleurs, l'organe d'injection 21 peut prendre la forme d'une série de passages tubulaires de faible longueur, répartis linéairement ou en quinconces entre les parois 14 et 15. De façon préférée, cet organe d'injection 21 est formé par une fente unique, s'étendant transversalement entre les parois précitées 14 et 15.

Le débouché amont de l'organe d'admission 20 est mis en communication avec une source d'alimentation en un premier gaz, dont la nature va être détaillée ci-après, alors que le débouché aval de l'organe d'injection 21 est placé en regard du substrat. L'axe principal A21 de l'organe d'injection 21 est radial, en référence au tambour 2. En d'autres termes, cet axe s'étend de façon sensiblement perpendiculaire au substrat défilant.

Comme le montrent notamment les figures 3 et 4, la chambre intermédiaire 22 est formée autour d'un noyau central 23, réalisé sous forme d'une coque pleine. Par conséquent, le gaz ne peut pénétrer dans ce noyau, de sorte qu'il est forcé de s'écouler le long de celui-ci comme cela va être détaillé ci-après. Ce noyau présente, en coupe transversale sur la figure 3, une forme globalement triangulaire. Il possède une face dite amont 231, horizontale sur les figures, laquelle est tournée vers la conduite d'admission, ainsi que des faces latérales 232 s'étendant à partir de la face amont.

Comme le montre la vue transversale de la figure 3, la chambre intermédiaire 22 est symétrique par rapport à un axe médian A1 du bloc. Cette chambre comporte tout d'abord une région amont 24, s'étendant à partir du passage d'admission 20. Cette région est formée par deux conduites 25 et 26 s'étendant globalement tangentiellement en référence au support 2, à savoir de manière horizontale sur les figures. Les entrées 25E et 26E de ces conduites prolongent le passage 20, alors que les sorties 25S et 26S débouchent dans la région aval 27, qui va être décrite ci-après.

En service le premier gaz s'écoule tout d'abord selon une première direction, qui correspond à l'axe principal A20 du passage 20, c'est-à-dire de façon sensiblement verticale. Puis ce gaz progresse de façon sensiblement horizontale dans ces conduites 25 et 26, à savoir selon une deuxième direction qui est globalement perpendiculaire à la première direction évoquée ci-dessus. Par ailleurs, la section de passage du premier gaz augmente depuis l'entrée vers la sortie de chaque conduite de cette région amont. On retrouve cette augmentation de section, à la fois en vue longitudinale (soit selon l'axe XX visible sur les figures 2 et 4) et en vue transversale (soit selon l'axe ; YY visible sur les figures 3 et 4). A titre de variante, on peut prévoir que cette section de passage augmente uniquement selon l'une des deux directions XX ou YY, étant entendu qu'une augmentation selon ces deux directions à la fois est tout particulièrement avantageuse.

La chambre intermédiaire 22 comporte en outre une région aval 27, s'étendant à partir de la région amont 24 décrite ci-dessus. Cette région est formée par deux conduites 28 et 29 s'étendant globalement radialement en référence au support 2, à savoir de manière verticale sur les figures. Les entrées 28E et 29E de ces conduites prolongent les conduites amont 25 et 26, alors que les sorties 28S et 29S débouchent dans la fente d'injection 21.

En service, à la sortie de la région amont, le premier gaz est renvoyé, notamment selon un angle globalement droit, en direction de la région aval de la chambre. Ce gaz s'écoule alors de façon sensiblement verticale dans les conduites 28 et 29, à savoir selon une troisième direction qui est globalement perpendiculaire à la deuxième direction évoquée ci-dessus. La progression du gaz dans la chambre intermédiaire est matérialisée, sur les figures, par les flèches successives G.

Par ailleurs, en vue transversale selon l'axe YY, à savoir sur la figure 3, la section de passage du premier gaz augmente depuis l'entrée 28E ou 29E vers la sortie 28S ou 29S de chaque conduite 28 ou 29 de cette région aval. En revanche, en vue longitudinale selon l'axe XX, à savoir sur la figure 2, la section de passage du premier gaz diminue au voisinage de la sortie 28S ou 29S de chaque conduite 28 ou 29 de cette région aval. Cette diminution de section correspond à la jonction entre chaque conduite aval 28, 29 et la fente d'injection 21.

Sans vouloir être lié par la théorie, on peut considérer que le premier gaz est admis dans le passage 20 en présentant un flux de forme cylindrique. Puis, il est introduit dans la chambre 22, où il subit une détente afin de perdre cette forme cylindrique. Ce gaz est ensuite poussé progressivement vers la fente d'injection 21, afin qu'il sorte de l'unité 1 en forme de lame de gaz.

Les seconds moyens d'injection présentent une structure similaire à celle des premiers moyens d'injection, décrits ci-dessus. Par conséquent, les éléments mécaniques de ces seconds moyens, qui sont analogues à ceux des premiers moyens, sont affectés des mêmes numéros de référence augmentés de 10.

Ces seconds moyens d'injection comprennent essentiellement un organe d'admission 30, un organe d'injection 31, ainsi qu'une chambre intermédiaire 32. Chacun de ces organes 30 et 31 présente une section de passage sensiblement constante, entre ses extrémités amont et aval. Avantageusement, la section de passage du gaz dans l'organe d'injection est supérieure à la section de passage dans l'organe d'admission. La section totale d'admission est par exemple comprise entre 0.07 et 1.2 cm², alors que la section totale d'injection est par exemple comprise entre 0.3 et 2 cm². Le débouché amont de l'organe 30 est mis en communication avec une source d'alimentation en un second gaz, dont la nature va être détaillée ci-après, alors que le débouché aval de l'organe d'injection 31 est placé en regard du substrat.

Selon une caractéristique tout particulièrement avantageuse de l'invention, l'axe principal A31 de l'organe d'injection 31 est incliné par rapport à un rayon du tambour 2, en direction de l'amont en faisant référence au défilement du substrat. En d'autres termes, cet organe d'injection 31 s'étend de façon oblique, en étant tourné vers l'organe d'injection 21 du premier gaz. On note α31 l'angle formé par les axes A21 et A31, lequel est compris entre 20° et 70°, préférentiellement entre 40° et 50°, notamment voisin de 45°. De plus la distance d3 entre les débouchés des organes d'injection 21 et 31 est avantageusement inférieure à 10 mm, de préférence à 4 mm. Cette distance d3 est calculée entre les centres respectifs de ces débouchés. Prévoir une telle géométrie est avantageux, comme cela sera décrit dans ce qui suit.

La chambre intermédiaire 32 présente globalement la même structure et la même fonction, que la chambre 22 décrite ci-dessus. Cependant, les formes et les dimensions de cette chambre 32 peuvent varier, par rapport à celles de la chambre 22, notamment afin de s'adapter à l'encombrement global de l'unité de traitement 1A. La chambre intermédiaire 32 est formée autour d'un noyau central, analogue à celui 23 ci-dessus, qui n'est cependant pas représenté sur les figures.

Cette chambre 32 comporte tout d'abord une région amont, s'étendant à partir du passage d'admission 30. Cette région est formée par deux conduites, dont seule l'une 36 est visible sur la figure 2. Les entrées (dont seule celle 36E est représentée sur la figure 2) de chaque conduite prolongent le passage 30. Par ailleurs, les sorties (dont seule celle 36S est représentée sur la figure 2) de chaque conduite amont débouchent dans une région aval, formée par deux conduites dont l'une 39 est visible sur la figure 2. Les entrées (dont seule celle 39E est représentée sur la figure 2) de chaque conduite aval prolongent les conduites, alors que les sorties (dont seule celle 39S est représentée sur la figure 2) débouchent dans la fente d'injection 31.

Le bloc 1A est en outre creusé d'au moins un logement 50, dont chacun est destiné à la réception d'une électrode correspondante non représentée. Dans l'exemple illustré, on retrouve un unique logement, étant entendu qu'on peut prévoir plusieurs logements disposés les uns derrière les autres, selon la direction de défilement du substrat. Ce logement 50 débouche avantageusement sur au moins une des parois latérales du bloc, à savoir vers l'avant et/ou l'arrière de la feuille sur la figure 2. Ceci permet une accessibilité aisée de ce logement pour l'utilisateur, de sorte que celui-ci peut enfiler directement l'électrode dans le logement qui lui est dédié.

L'électrode, qui est par exemple allongée à la manière d'un barreau, présente une section transversale carrée. Avantageusement cette électrode possède des bords arrondis, qui coopèrent à ajustement serré avec des bords arrondis 50', ménagés sur les parois du logement 50. Le rayon de courbure de ces bords arrondis est par exemple compris entre 0.5 mm et 10 mm. De façon avantageuse, les bords de l'électrode ne sont pas métallisés, de manière à éviter la remontée du plasma au voisinage de ces bords. Par conséquent, on constate avantageusement une concentration du plasma entre l'électrode et le substrat.

De manière préférée, la distance entre les parois en regard de l'électrode et du substrat est sensiblement constante, en étant sensiblement égale à la valeur d1 ci-dessus. On utilise avantageusement des électrodes en forme de barreau plat, dont la largeur est faible. Par conséquent, les variations de la distance entre cette électrode et le substrat sont négligeables. Cette caractéristique permet d'éviter tout seuil ou discontinuité dans l'espace entre électrode et substrat, de façon à empêcher toute recirculation significative de gaz. Dans ces conditions, un écoulement substantiellement laminaire de ce gaz est assuré.

Par ailleurs la plus petite distance d2 séparant les débouchés respectifs, appartenant à la conduite 31 et au logement 50, est avantageusement inférieure à 20 mm et, de manière préférentielle, inférieure à 15 mm. Cela permet de conserver une concentration maximale du gaz auxiliaire, notamment des dopants contenus dans ce dernier, au voisinage de la surface du substrat.

Avantageusement chaque électrode a une surface extérieure lisse, ce qui évite la création de turbulence dans la zone de formation du plasma. Cette électrode est de préférence réalisée en matériau céramique, ce qui permet de traiter un substrat électriquement conducteur. A titre d'alternative, les électrodes peuvent être réalisées en tout autre matériau approprié, comme en matériau métallique. Cette électrode est connectée à une source de puissance, non représentée.

Des moyens non représentés, de tout type approprié, sont prévus afin de maintenir en position l'électrode dans son logement. De manière avantageuse, chaque électrode est en particulier fixée de manière amovible, par exemple par encliquetage. Par conséquent, une électrode donnée peut être remplacée par une autre électrode similaire, en particulier en cas de défaillance. Cette électrode peut aussi être remplacée par une autre électrode, de type différent. L'expression « électrodes différentes » signifie qu'au moins un des paramètres suivants varie d'un tube à l'autre :
- Dimension totale de l'électrode.
- Matériau de l'électrode.
- Forme de l'électrode.

Chaque bloc est réalisé dans un matériau isolant, tel qu'un polymère, un composite, du bois, ou encore de la céramique. De manière préférentielle, le matériau constitutif du bloc est un composite renforcé en poudre céramique, ce qui permet de combiner la facilité d'usinage avec la résistance thermique et mécanique. La forme de chaque chambre 22 et 32, qui peut être définie par modélisation numérique, est alors intégrée à la réalisation du bloc.

Dans une première variante, le bloc est formé de plusieurs éléments constitutifs, qui sont ensuite collés ou soudés les uns avec les autres. Dans ce cas, les chambres peuvent être usinées. A titre de variante avantageuse, le bloc est formé d'un unique élément constitutif. Dans ce cas, les chambres sont réalisées de manière simultanée par des méthodes telles que le prototypage rapide, la stéréolithographie ou l'impression en trois dimensions, encore dénommée « impression 3D ». Ces méthodes de fabrication permettent d'éviter la présence de joints de colle ou de joints d'assemblage sur l'unité, en particulier à l'intérieur de ces chambres d'injection.

L'installation de traitement de la figure 1 comprend en outre un capot dit de confinement 4, permettant de conférer une atmosphère de traitement contrôlée. En coupe transversale ce capot 4 présente une forme dite de U à ailes évasées. Il comprend une paroi supérieure ou âme 41, deux parois frontales ou ailes 42 et 43, ainsi que deux parois latérales 44 et 45 visibles sur la figure 1. En référence au sens de rotation du tambour, l'aile 42 est dénommée aile amont, alors que l'aile 43 est dénommée aile aval.

De manière avantageuse, on choisit certaines dimensions caractéristiques dans une plage de valeurs parfaitement définie :
- la plus petite distance d'1 entre le bord d'extrémité de la paroi amont 42 du capot 4 et le rouleau presseur 3 est choisie inférieure à 15 millimètres, de préférence inférieure à 5 millimètres ;
- la plus petite distance entre la paroi amont 42 du capot 4 et l'ensemble de traitement est choisie inférieure à 20 millimètres, de préférence inférieure à 2 millimètres. Cette distance sépare la paroi précitée 42 par rapport au bord supérieur du bloc 1A;
- la plus petite distance entre l'extrémité amont de l'ensemble de traitement et le support est choisie inférieure à 5 millimètres, de préférence inférieure à 2 millimètres.
- la plus petite distance entre un premier bloc de traitement, tel celui 1A, et le bloc de traitement suivant, tel celui 1B, est choisie entre d'1 et 10 mm, de préférence entre d'1 et 2* d'1 (où d'1 est telle que définie ci-dessus). Dans le cas d'un bloc de traitement unique, cette distance sépare ce bloc de traitement et la paroi aval en regard du capot de confinement.

Avantageusement on recycle une partie du gaz de traitement, depuis l'organe d'injection 21 vers l'amont de l'unité. Tout ou partie du gaz de traitement ainsi recyclé est alors admis dans un volume de recirculation, délimité selon l'invention par le bord d'extrémité de la paroi frontale amont du capot, par le rouleau presseur, par le support et par l'extrémité amont de l'ensemble de traitement. Le fait de positionner ce bord d'extrémité au plus près du rouleau presseur facilite le refoulement de l'air ambiant, par l'intermédiaire du gaz de traitement présent dans ce volume de recirculation. En d'autres termes, on empêche toute entrée significative d'air ambiant dans ce volume de recirculation et, par conséquent, en direction de la zone de traitement.

Différentes possibilités de mise en oeuvre de l'installation, conforme à l'invention, vont maintenant être explicitées dans ce qui suit.

De manière générale, on dirige des premier et deuxième gaz vers le substrat défilant, grâce aux premiers et deuxièmes moyens d'injection décrits ci-dessus. Le premier gaz, encore dénommé gaz de traitement, comprend au moins un gaz plasmagène tel que l'azote, l'argon, ou encore l'hélium. Dans le présent mode de réalisation, ce gaz de traitement est constitué sensiblement par le gaz plasmagène précité. Dans ce mode de réalisation, le deuxième gaz, encore dénommé gaz auxiliaire, comprend d'autres gaz ou composés vaporisés de type connu en soi, appelés dopants.

De manière avantageuse, la largeur de la fente d'injection 21, à savoir sa dimension selon XX, est calculée en fonction d'un débit de gaz plasmagène admis en entrée. On dimensionne cette largeur, afin que la vitesse du gaz en sortie soit comprise entre 1 m/s et 20 m/s. De manière préférée, cette vitesse du gaz est voisine de la vitesse de défilement du substrat. Typiquement, pour un débit de 50 m³/h en gaz plasmagène et une longueur (selon YY) de fente de 20 centimètres, la largeur est de 1.5 millimètres.

A titre de variantes de réalisation, on peut prévoir que le gaz de traitement comprend, outre le gaz plasmagène, d'autres composés tels que les dopants décrits ci-dessus. On peut également prévoir que le gaz auxiliaire comprend, outre les dopants, une fraction de gaz plasmagène, ou encore un autre composant tel un spray ou un brouillard.

Le gaz plasmagène injecté par les conduites 21 s'écoule tout d'abord vers l'aval, entre la paroi inférieure 16 et le substrat SUB. Par ailleurs des dopants sont dirigés vers le substrat, via le deuxième organe d'injection 31. La position des conduites d'injection 21, 31, notamment leur angle d'inclinaison mutuelle, permet de concentrer les dopants au voisinage du substrat par un effet de plaquage. Cet effet est tout particulièrement avantageux, dans la mesure où il permet de maximiser la vitesse de traitement. Dans le cas d'un dépôt, il permet de plus de réduire la formation intempestive de poudre sur l'électrode. Cela permet de remédier, dans une mesure significative, aux inconvénients de WO-A-2016/128259 présentés ci-dessus.

On notera que, dans le mode de réalisation des figures 1 à 4, cet effet de plaquage est assuré alors que les moyens d'injection des premier et second gaz comprennent une chambre intermédiaire d'homogénéisation. Cependant, on peut retrouver cet effet de plaquage avec des moyens d'injection différents de ceux des figures 1 à 4, notamment des moyens d'injection dépourvus d'une telle chambre intermédiaire.

Dans cet esprit les premiers moyens d'injection peuvent comprendre plusieurs conduites, réparties régulièrement selon l'axe YY. Sur la figure 5, on a illustré l'une de ces conduites, s'étendant entre les parois supérieure et inférieure du bloc, dont la partie amont forme l'organe d'admission 120 et la partie aval l'organe d'injection 121. De plus les seconds moyens d'injection comprennent également plusieurs conduites, réparties régulièrement selon l'axe YY. Sur la figure 5, on a illustré l'une de ces conduites, s'étendant entre les parois supérieure et inférieure du bloc, dont la partie amont forme l'organe d'admission 130 et la partie aval l'organe d'injection 131. La partie amont 130 est parallèle à la conduite 120, alors que la partie aval 131 est inclinée, de manière à former avec la conduite 120 un angle α131, dont la valeur est similaire à celle de α31 décrit ci-dessus.

Le fait que la conduite 131, destinée à l'injection du deuxième gaz, est inclinée en direction de la conduite 120, destinée à l'injection du premier gaz, confère également l'effet de plaquage ci-dessus. A titre de variantes supplémentaires, non représentées, on peut prévoir que les moyens d'injection comprennent une chambre intermédiaire dont la forme est différente de celle illustrée sur les figures, notamment une forme simplifiée telle que connue de l'état de la technique.

Dans la variante de réalisation représentée sur les figures 1 à 5, l'installation conforme à l'invention comprend plusieurs unités 1A à 1D, disposées les unes derrière les autres selon la direction de défilement du substrat. Selon une caractéristique avantageuse, on peut injecter des gaz de traitement et/ou des gaz auxiliaires différents d'une unité à l'autre. Cela permet de mettre en oeuvre des traitements différents en un seul passage.

La figure 6 illustre une variante supplémentaire de réalisation de l'invention, dans laquelle l'installation conforme à l'invention comprend plusieurs unités 1a jusqu'à 1n, disposées les unes à côté des autres en référence à la direction de défilement, à savoir selon l'axe YY. Ces unités de traitement élémentaires peuvent être placées les unes à côté des autres au sein de leur logement commun, sans moyen de fixation spécifique. On peut également prévoir, comme illustré sur la figure 6, que des unités voisines sont équipées de moyens de fixation mutuelle, notamment de type amovible. Sur cette figure 6, on retrouve une fixation au moyen de tenons 18b à 18n, équipant une première unité, lesquels coopèrent avec des mortaises complémentaires 19a à 19(n-1), équipant l'unité adjacente.

Le mode de réalisation de la figure 6 présente des avantages spécifiques. En effet, il permet le traitement de substrats de grande largeur, tout en utilisant des unités de traitement individuelles de petite taille. On peut prévoir de placer côte à côte un nombre d'unités, qui peut varier de 2 jusqu'à n, où n est par exemple voisin de 10. Ainsi, dans le cas où on dispose côte à côte 10 unités dont la dimension selon YY est de 20 à 30 centimètres, on dispose d'une dimension totale de traitement de 2 à 3 mètres, selon YY. On notera que, sur cette figure 6, les unités ne sont pas nécessairement représentées à l'échelle réelle, dans un but de clarté. Dans la réalité, ces unités peuvent en effet présenter des dimensions supérieures, selon l'axe YY.

Le fait de prévoir des unités de petite taille, selon l'axe YY, permet une fabrication plus simple, ainsi qu'une utilisation plus commode. Par ailleurs, la taille réduite des unités assure une répartition satisfaisante des gaz selon YY, par rapport à une unité de plus grande dimension. Enfin ce mode de réalisation est avantageux, en termes de flexibilité. En pratique, on réalise un grand nombre d'unités individuelles identiques, que l'on assemble en un nombre voulu en fonction de la largeur de chaque laize à traiter.

### Exemples

L'invention est illustrée ci-dessous par un exemple qui n'en limite cependant pas la portée. Cet exemple porte sur un type de traitement plasma et sur la mesure de l'énergie de surface après traitement.

On utilise une installation telle que celle décrite aux figures 1 à 4. Cette installation comprend un tambour 2, dont le diamètre est 400 mm, ainsi que sept blocs de traitement identiques, tels celui 1A. Chacun de ces blocs possède des premiers orifices d'injection 21 d'une surface totale de 400 mm², ainsi que des deuxièmes orifices d'injection 31 d'une surface totale de 100 mm². La dimension caractéristique (d1) est égale à 1 millimètre.

On fait défiler un film de BOPP, dont la largeur est 550 mm et dont l'épaisseur est de 20 µm (micromètres). On utilise, en tant que gaz plasmagène ou premier gaz, du N₂ et, en tant que gaz réactif ou deuxième gaz, du C₂H₂.

L'énergie de surface obtenue est mesurée après traitement avec des encres tests calibrées suivant la norme ASTM D-2578. Avant traitement, le film a une énergie de surface de 30 mN/m.
* Dans une première mise en oeuvre, conforme à l'invention, on injecte le gaz plasmagène à des débits respectifs de 50 m³/h et le gaz réactif à 5 I/h. Cette configuration a conduit à une énergie de surface de 58 mN/m à 600 m/min.
* On a ensuite réalisé, à titre comparatif, une seconde mise en oeuvre, qui n'est pas conforme à l'invention. A cet effet, l'installation diffère en trois points de celle présentée ci-dessus:
   - l'angle α31 est de 135° ;
   - les chambres 22 et 32 ont été remplacées par des cavités cylindriques de 5 mm de diamètre ;
   - la distance d20 est égale à 0 mm.

Les autres éléments constitutifs de l'installation, ainsi que les débits de gaz, sont identiques à ceux de la première mise en oeuvre ci-dessus.

Dans ce cas, la vitesse maximale qui conduit à une énergie de surface de 58 mN/m est de 200 m/min.

La meilleure répartition des gaz, ainsi que le plaquage des gaz réactifs contre la surface de traitement, ont donc conduit à une augmentation de la vitesse de traitement d'un facteur 3 pour la même haute qualité de traitement. L'invention est définie par les revendications.

## Revendications

1. Unité de traitement (1A) pour une installation de traitement de surface d'un substrat (SUB) en mouvement, cette installation comprenant en outre
- un support (2) pour le substrat,
- une contre électrode, notamment confondue avec le support ; cette unité de traitement comprenant
- au moins une électrode adaptée pour coopérer avec ladite contre électrode pour créer une décharge électrique;
- au moins un logement (50) de réception d'au moins l'électrode;
- des premiers moyens (20, 21, 22) d'injection pour l'injection d'un premier gaz, ou gaz de traitement, vers ledit support, ce premier gaz comprenant au moins un gaz plasmagène ;
dans laquelle es premiers moyens d'injection comprennent
- un organe d'admission (20) du premier gaz, destiné à être mis en communication avec une source d'alimentation en ce premier gaz, cet organe d'admission présentant un axe principal (A20) définissant une première direction d'écoulement du gaz,
- un organe d'injection (21) du premier gaz, débouchant en regard du support,
- une chambre intermédiaire (22) reliant ces deux organes respectifs d'admission et d'injection,
cette chambre intermédiaire comportant
- une région amont (24), s'étendant à partir de l'organe d'admission (20), la chambre intermédiaire étant configurée de sorte que le premier gaz s'écoule en service selon une deuxième direction dans cette région amont, ladite deuxième direction étant oblique, notamment perpendiculaire, par rapport à ladite première direction, et de sorte que la section de passage du premier gaz augmente augmentant depuis l'entrée (25E, 26E) vers la sortie (25S, 26S) de la région amont en vue longitudinale (XX) et/ou en vue transversale (YY),
- ainsi qu'une région aval (27), s'étendant entre la région amont (24) et l'organe d'injection (21), la chambre intermédiaire étant configurée de sorte que le premier gaz s'écoule en service selon une troisième direction dans cette région aval, ladite troisième direction étant oblique, notamment perpendiculaire, par rapport à ladite deuxième direction, et de sorte que la section de passage du premier gaz augmente depuis l'entrée (28E, 29E) vers la sortie (28S, 29S) de la région aval en vue transversale (YY), mais que la section de passage du premier gaz diminue au voisinage de la sortie (28S, 29S) de la région aval en vue longitudinale (XX).

2. Unité de traitement selon la revendication 1, dans laquelle a chambre intermédiaire est symétrique par rapport à un axe médian (A1) de l'unité (1A), en vue transversale (YY), la région amont (24) étant formée par deux conduites amont (25, 26) s'étendant de part et d'autre dudit axe médian, la région aval (27) étant formée par deux conduites aval (28, 29) s'étendant de part et d'autre dudit axe médian et prolongeant chacune une conduite amont respective.

3. Unité de traitement selon la revendication 1 ou 2, dans laquelle a chambre intermédiaire (22) est formée autour d'un noyau central (23) possédant une face amont (231) tournée vers l'organe d'admission (20), ainsi que des faces latérales (232) s'étendant à partir de la face amont (231), le noyau central étant notamment de forme triangulaire.

4. Unité de traitement selon l'une des revendications 1 à 3, dans laquelle l'organe d'injection (21) s'étend sur sensiblement toute la largeur de l'unité, en étant notamment formée par une fente unique.

5. Unité de traitement selon l'une des revendications 1 à 4, dans laquelle cette unité comprend en outre des deuxièmes moyens d'injection (30, 31, 32) pour l'injection d'un deuxième gaz vers ledit support, ces deuxièmes moyens d'injection comprenant un organe d'injection (31) du deuxième gaz, débouchant en regard du support, l'organe d'injection du deuxième gaz étant incliné en direction de l'organe d'injection (21) du premier gaz, en vue longitudinale.

6. Unité de traitement selon la revendication précédente, dans laquelle les deuxièmes moyens d'injection (30, 31, 32) comprennent en outre un organe d'admission (30) du deuxième gaz, destiné à être mis en communication avec une source d'alimentation en ce deuxième gaz, ainsi qu'une chambre intermédiaire (32) reliant les deux organes respectifs d'admission et d'injection, cette chambre intermédiaire comportant
- une région amont (36), s'étendant à partir de l'organe d'admission (30), la chambre intermédiaire étant configurée de sorte que le premier gaz s'écoule en service selon une deuxième direction dans cette région amont, ladite deuxième direction étant oblique, notamment perpendiculaire, par rapport à ladite première direction, et de sorte que la section de passage du premier gaz augmente depuis l'entrée (36E) vers la sortie (36S) de la région amont en vue longitudinale et/ou en vue transversale,
- ainsi qu'une région aval (39), s'étendant entre la région amont (26) et l'organe d'injection (31), la chambre intermédiaire étant configurée de sorte que le premier gaz s'écoule en service selon une troisième direction dans cette région aval, ladite troisième direction étant oblique, notamment perpendiculaire, par rapport à ladite deuxième direction, et de sorte que a section de passage du premier gaz augmente depuis l'entrée (39E) vers la sortie (39S) de la région aval, en vue transversale, mais que la section de passage du premier gaz diminue au voisinage de la sortie (39S) de la région aval, en vue longitudinale.

7. Unité de traitement selon la revendication 5 ou 6, dans laquelle les axes principaux, respectivement de l'organe d'injection du premier gaz et de l'organe d'injection du deuxième gaz, forment un angle (α31) compris entre 20° et 70°, notamment entre 40° et 50°, en particulier voisin de 45°.

8. Unité de traitement selon l'une des revendications 5 à 7, dans laquelle les débouchés, respectivement de l'organe d'injection (21) du premier gaz et de l'organe d'injection (31) du deuxième gaz, sont séparés d'une distance (d3) inférieure à 10 millimètres, en particulier inférieure à 4 millimètres.

9. Unité de traitement selon l'une des revendications 5 à 8, dans laquelle les débouchés, respectivement du logement (50) et de l'organe d'injection (31) du second gaz, sont séparés d'une distance (d2) inférieure à 20 millimètres, en particulier inférieure à 15 millimètres.

10. Unité de traitement selon l'une des revendications précédentes, dans laquelle l'unité comprend des bords inférieurs respectivement amont et aval de forme arrondie, dont le rayon de courbure est compris entre 0.5 millimètre et 10 millimètres.

11. Unité de traitement selon l'une des revendications précédentes, dans laquelle l'électrode est reçue à ajustement serré dans son logement, cette électrode et ces parois comprenant des bords de forme arrondie, dont le rayon de courbure est compris entre 0.5 millimètre et 10 millimètres.

12. Unité de traitement selon l'une des revendications précédentes, dans laquelle, en vue longitudinale (XX), l'organe d'admission (20) est placé en avant, ou en aval, par rapport à l'organe d'injection (21), en référence au défilement du substrat en service.

13. Unité de traitement selon l'une des revendications précédentes, dans laquelle cette unité est réalisée sous forme d'un bloc massif dont la paroi inférieure (16), en regard du support (2), est sensiblement pleine, la distance (d1) entre cette paroi inférieure et le support étant sensiblement constante selon la direction longitudinale, cette distance étant notamment inférieure à 5 millimètres, en particulier inférieure à 2 millimètres.

14. Installation de traitement de surface d'un substrat (SUB) en mouvement, comprenant
- un support (2) pour le substrat,
- une contre électrode, notamment confondue avec le support ;
- un ensemble de traitement placé en aval d'un rouleau presseur, en référence au défilement du substrat, ledit ensemble comprenant au moins une unité de traitement (1A - 1D) selon l'une des revendications précédentes ;
- au moins une source de gaz de traitement et éventuellement au moins une source de gaz auxiliaire, aptes à alimenter les premiers moyens d'injection et éventuellement les deuxièmes moyens d'injection de chaque unité de traitement.

15. Procédé de mise en oeuvre d'une installation de traitement de surface selon la revendication précédente, cette installation comprenant une unité selon l'une des revendications 5 à 13, procédé dans lequel on fait défiler le substrat, on injecte du gaz de traitement en direction de ce substrat, et on injecte du gaz auxiliaire en direction de ce substrat, de manière à plaquer au moins une partie de ce gaz auxiliaire au voisinage de ce substrat.

## Patentansprüche

1. Behandlungseinheit (1A) für eine Anlage zur Behandlung der Oberfläche eines Substrats (SUB) in Bewegung, wobei diese Anlage weiter umfasst
- eine Halterung (2) für das Substrat,
- eine Gegenelektrode, insbesondere mit der Halterung zusammengenommen;
wobei diese Behandlungseinheit umfasst
- mindestens eine Elektrode, die angepasst ist, um mit der Gegenelektrode zusammenzuwirken, um eine elektrische Entladung zu kreieren;
- mindestens eine Aufnahme (50) zum Empfangen mindestens der Elektrode;
- erste Injektionsmittel (20, 21, 22) zum Injizieren eines ersten Gases, oder Behandlungsgases zu der Halterung, wobei dieses erste Gas mindestens ein plasmaerzeugendes Gas umfasst;
wobei die ersten Injektionsmittel umfassen
- ein Einlassorgan (20) des ersten Gases, das dazu bestimmt ist, in Kommunikation mit einer Versorgungsquelle für dieses erste Gas gebracht zu werden, wobei dieses Einlassorgan eine Hauptachse (A20) aufweist, die eine erste Strömungsrichtung des Gases definiert,
- ein Injektionsorgan (21) des ersten Gases, das gegenüber der Halterung einmündet,
- eine Zwischenkammer (22), die diese beiden jeweiligen Einlass- und Injektionsorgane verbindet,
wobei diese Zwischenkammer beinhaltet
- eine stromaufwärtige Region (24), die sich aus dem Einlassorgan (20) erstreckt, wobei die Zwischenkammer derart konfiguriert ist, dass das erste Gas in Betrieb entlang einer zweiten Richtung in dieser stromaufärtigen Region strömt, wobei die zweite Richtung schräg, insbesondere senkrecht in Bezug auf die erste Richtung ist, und derart, dass sich die Durchgangssektion des ersten Gases von dem Eingang (25E, 26E) zum Ausgang (25S, 26S) der stromaufwärtigen Region in Längsansicht (XX) und/oder in Queransicht (YY) vergrößert,
- sowie eine stromabwärtige Region (27), die sich zwischen der stromaufwärtigen Region (24) und dem Injektionsorgan (21) erstreckt, wobei die Zwischenkammer derart konfiguriert ist, dass das erste Gas in Betrieb entlang einer dritten Richtung in dieser stromabwärtigen Region strömt, wobei die dritte Richtung schräg, insbesondere senkrecht in Bezug auf die zweite Richtung ist, und derart, dass sich die Durchgangssektion des ersten Gases von dem Eingang (28E, 29E) zum Ausgang (28S, 29S) der stromabwärtigen Region in Queransicht (YY) vergrößert, sich jedoch die Durchgangssektion des ersten Gases im Umfeld des Ausgang (28S, 29S) der stromabwärtigen Region in Längsansicht (XX) verkleinert.

2. Behandlungseinheit nach Anspruch 1, wobei die Zwischenkammer in Bezug auf eine Mittelachse (A1) der Einheit (1A) in Queransicht (YY) symmetrisch ist, wobei die stromaufwärtige Region (24) durch zwei stromaufwärtige Leitungen (25, 26) gebildet werden, die sich beiderseits der Mittelachse erstrecken, wobei die stromabwärtige Region (27) durch zwei stromabwärtige Leitungen (28, 29) gebildet werden, die sich beiderseits der Mittelachse erstrecken und jede eine jeweilige stromaufwärtige Leitung verlängert.

3. Behandlungseinheit nach Anspruch 1 oder 2, wobei die Zwischenkammer (22) um einen zentralen Kern (23) gebildet ist, der eine stromaufwärtige Fläche (231) besitzt, die zum Einlassorgan (20) gedreht ist, sowie Seitenflächen (232), die sich aus der stromaufwärtigen Fläche (231) erstrecken, wobei der zentrale Kern insbesondere von einer dreieckigen Form ist.

4. Behandlungseinheit nach einem der Ansprüche 1 bis 3, wobei sich das Injektionsorgan (21) über im Wesentlichen die gesamte Breite der Einheit erstreckt, und insbesondere durch einen einzelnen Schlitz gebildet ist.

5. Behandlungseinheit nach einem der Ansprüche 1 bis 4, wobei diese Einheit weiter zweite Injektionsmittel (30, 31, 32) zum Injizieren eines zweiten Gases zu der Halterung umfasst, wobei diese zweiten Injektionsmittel ein injektionsorgan (31) des zweiten Gases umfassen, gegenüber der Halterung einmündend, wobei das Injektionsorgan des zweiten Gases in Richtung des Injektionsorgans (21) des ersten Gases in Längsansicht geneigt ist.

6. Behandlungseinheit nach dem vorstehenden Anspruch, wobei die zweiten Injektionsmittel (30, 31, 32) weiter ein Einlassorgan (30) des zweiten Gases umfassen, das dazu bestimmt ist, in Kommunikation mit einer Verrsorgungsquelle dieses zweiten Gases gebracht zu werden, sowie eine Zwischenkammer (32), die die jeweiligen beiden Einlass- und Injektionsorgane verbindet,
wobei diese Zwischenkammer beinhaltet
- eine stromaufwärtige Region (36), die sich aus dem Einlassorgan (30) erstreckt, wobei die Zwischenkammer derart konfiguriert ist, dass das erste Gas in Betrieb entlang einer zweiten Richtung in dieser stromaufärtigen Region strömt, wobei die zweite Richtung schräg, insbesondere senkrecht in Bezug auf die erste Richtung ist, und derart, dass sich die Durchgangssektion des ersten Gases von dem Eingang (36E) zum Ausgang (36S) der stromaufwärtigen Region in Längsansicht und/oder in Queransicht vergrößert,
- sowie eine stromabwärtige Region (39), die sich zwischen der stromaufwärtigen Region (26) und dem Injektionsorgan (31) erstreckt, wobei die Zwischenkammer derart konfiguriert ist, dass das erste Gas in Betrieb entlang einer dritten Richtung in dieser stromabwärtigen Region strömt, wobei die dritte Richtung schräg, insbesondere senkrecht in Bezug auf die zweite Richtung ist, und derart, dass sich die Durchgangssektion des ersten Gases von dem Eingang (39E) zum Ausgang (39S) der stromabwärtigen Region in Queransicht vergrößert, sich die Durchgangssektion des ersten Gases jedoch in der Umgebung des Ausgangs (39S) der stromabwärtigen Region in Längsansicht verkleinert.

7. Behandlungseinheit nach Anspruch 5 oder 6, wobei die Hauptachsen, jeweils des Injektionsorgans des ersten Gases und des Injektionsorgans des zweiten Gases eine Winkel (α31) bilden, der zwischen 20° und 70°, insbesondere zwiscen 40° und 50° enthalten ist, inbesondere nahe 45° ist.

8. Behandlungseinheit nach einem der Ansprüche 5 bis 7, wobei die Einmündungen jeweils des Injektionsorgans (21) des ersten Gases und des Injektionsorgans (31) des zweiten Gases um einen Abstand (d3) kleiner als 10 Millimeter, insbesondere kleiner als 4 Millimeter getrennt sind.

9. Behandlungseinheit nach einem der Ansprüche 5 bis 8, wobei die Einmündungen, jeweils der Aufnahme (50) und des Injektionsorgans (31) des zweiten Gases um einen Abstand (d2) kleiner als 20 Millimeter, insbesondere kleiner als 15 Millimeter getrennt sind.

10. Behandlungseinheit nach einem der vorstehenden Ansprüche, wobei die Einheit jeweils stromaufwärtige und stromabwärtige untere Ränder in abgerundeter Form umfasst, deren Krümmungsradius zwischen 0,5 Millimeter und 10 Millimeter enthalten ist.

11. Behandlungseinheit nach einem der vorstehenden Ansprüche, wobei die Elektrode im Presssitz in ihrer Aufnahme empfangen wird, wobei diese Elektrode und diese Wände Ränder in abgerundeter Form umfassen, deren Krümmungsradius zwischen 0,5 Millimeter und 10 Millimeter enthalten ist.

12. Behandlungseinheit nach einem der vorstehenden Ansprüche, wobei in Längssicht (XX) das Einlassorgan (20) vor oder stromabwärts in Bezug auf das Injektionsorgan (21) mit Bezug auf den Durchlauf des Substrats in Betrieb platziert ist.

13. Behandlungseinheit nach einem der vorstehenden Ansprüche, wobei diese Einheit in Form eines massiven Blocks realisiert ist, dessen untere Wand (16) gegenüber der Halterung (2) im Wesentlichen voll ist, wobei der Abstand (d1) zwischen dieser unteren Wand und der Halterung im Wesentlichen entlang der Längsrichtung konstant ist, wobei dieser Abstand insbesondere kleiner als 5 Millimeter, insbesondere kleiner als 2 Millimeter ist.

14. Anlage zur Behandlung der Oberfläche eines Substrats (SUB) in Bewegung, Folgendes umfassend
- eine Halterung (2) für das Substrat,
- eine Gegenelektrode, insbesondere mit der Halterung zusammengenommen;
- eine Behandlungsbaugruppe, die mit Bezug auf den Durchlauf des Substrats stromabwärts einer Presswalze platziert ist, wobei die Einheit mindestens eine Behandlungseinheit (1A-1D) nach einem der vorstehenden Ansprüche umfasst;
- mindestens eine Behandlungsgasquelle und eventuell mindestens eine Hilfsgasquelle, die imstande sind, die ersten Injektionsmittel und eventuell die zweiten Injektionsmittel jeder Behandlungseinheit zu versorgen.

15. Verfahren zum Betreiben einer Anlage zur Behandlung einer Oberfläche nach dem vorstehenden Anspruch, wobei diese Anlage eine Einheit nach einem der Ansprüche 5 bis 13 umfasst, Verfahren, bei dem man das Substrat durchlaufen lässt, Behandlungsgas in Richtung dieses Substrats injiziert wird, Hilfsgas in Richtung dieses Substrats injiziert wird, um mindestens einen Teil dieses Hilfsgases in der Umgebung dieses Substrats zu plattieren.

## Claims

1. Treatment unit (1A) for a facility for the surface treatment of a substrate (SUB) in motion, this installation further comprising
- a support (2) for the substrate,
- a counter-electrode, in particular coincident with the support;
this treatment unit comprising
- at least one electrode suitable for cooperating with said counter-electrode in order to create an electrical discharge;
- at least one housing (50) for receiving at least the electrode;
- first injection means (20, 21, 22) for injecting a first gas, or treatment gas, towards said support, this first gas comprising at least one plasma-forming gas; **characterized in that** the first injection means comprise
- a member (20) for admission of the first gas, intended to be put in communication with a source supplying this first gas, this admission member having a principal axis (A20) defining a first direction of flow of the gas,
- a member (21) for injecting the first gas, emerging opposite the support,
- an intermediate chamber (22) connecting these two respective admission and injection members,
this intermediate chamber comprising
- an upstream region (24) extending from the admission member (20), the intermediate chamber being configured in such a way that the first gas flows in service in a second direction in this upstream region,
said second direction being oblique, in particular perpendicular, with respect to said first direction, and in such a way that the cross section of passage of the first gas increases from the inlet (25E, 26E) towards the outlet (25S, 26S) of the upstream region in longitudinal view (XX) and/or in transverse view (YY),
- as well as a downstream region (27) extending between the upstream region (24) and the injection member (21), the intermediate chamber being configured in such a way that the first gas flows in service in a third direction in this downstream region, said third direction being oblique, in particular perpendicular, with respect to said second direction, and in such a way that the cross section of passage of the first gas increases from the inlet (28E, 29E) towards the outlet (28S, 29S) of the downstream region in transverse view (YY), but the cross section of passage of the first gas decreases in the vicinity of the outlet (28S, 29S) of the downstream region in longitudinal view (XX).

2. Treatment unit according to claim 1, wherein the intermediate chamber is symmetrical with respect to a median axis (A1) of the unit (1A), in transverse view (YY), the upstream region (24) being formed by two upstream conduits (25, 26) extending on either side of said median axis, the downstream region (27) being formed by two downstream conduits (28, 29) extending on either side of said median axis and each extending a respective upstream conduit.

3. Treatment unit according to claim 1 or claim 2, wherein the intermediate chamber (22) is formed around a central core (23) having an upstream face (231) turned towards the admission member (20), and lateral faces (232) extending from the upstream face (231), the central core being in particular triangular in shape.

4. Treatment unit according to any of claims 1 to 3, wherein the injection member (21) extends over substantially the entire width of the unit, being in particular formed by a single slot.

5. Treatment unit according to any of claims 1 to 4, wherein this unit further comprises second injection means (30, 31, 32) for injecting a second gas towards said support, these second injection means comprising a member (31) for injecting the second gas, emerging opposite the support, the member for injecting the second gas being inclined in the direction of the member (21) injecting the first gas, in longitudinal view.

6. Treatment unit according to the preceding claim, wherein the second injection means (30, 31, 32) further comprise a member (30) for admitting the second gas, intended to be put in communication with a source supplying this second gas, as well as an intermediate chamber (32) connecting the two respective admission and injection members,
this intermediate chamber comprising
- an upstream region (36) extending from the admission member (30), the intermediate chamber being configured in such a way that the first gas flows in service in a second direction in this upstream region,
said second direction being oblique, in particular perpendicular, with respect to said first direction, in such a way that the cross section of passage of the first gas increases from the inlet (36E) towards the outlet (36S) of the upstream region in longitudinal view and/or in transverse view,
- as well as a downstream region (39) extending between the upstream region (26) and the injection member (31), the intermediate chamber being configured in such a way that the first gas flows in service in a third direction in this downstream region, said third direction being oblique, in particular perpendicular, with respect to said second direction, and in such a way that the cross section of passage of the first gas increases from the inlet (39E) towards the outlet (39S) of the downstream region, in transverse view, but the cross section of passage of the first gas decreases in the vicinity of the outlet (39S) of the downstream region, in longitudinal view.

7. Treatment unit according to claim 5 or claim 6, wherein the principal axes, respectively of the member injecting the first gas and of the member injecting the second gas, form an angle (α31) of between 20° and 70°, in particular between 40° and 50°, especially around 45°.

8. Treatment unit according to any of claims 5 to 7, wherein the outlets, respectively of the member (21) injecting the first gas and of the member (31) injecting the second gas, are separated by a distance (d3) of less than 10 millimetres, in particular less than 4 millimetres.

9. Treatment unit according to any of claims 5 to 8, wherein the outlets, respectively of the housing (50) and of the member (31) injecting the second gas, are separated by a distance (d2) of less than 20 millimetres, in particular less than 15 millimetres.

10. Treatment unit according to any of the preceding claims, wherein the unit comprises bottom edges, respectively upstream and downstream, that are rounded in shape, the radius of curvature of which is between 0.5 millimetres and 10 millimetres.

11. Treatment unit according to any of the preceding claims, wherein the electrode is received in a tight fit in its housing, this electrode and these walls comprising edges with a rounded shape, the radius of curvature of which is between 0.5 millimetres and 10 millimetres.

12. Treatment unit according to any of the preceding claims, wherein, in longitudinal view (XX), the admission member (20) is placed in front, or downstream, with respect to the injection member (21), with reference to the travel of the substrate in service.

13. Treatment unit according to any of the preceding claims, wherein this unit is produced in the form of a solid block, the bottom wall (16) of which, facing the support (2), is substantially solid, the distance (d1) between this bottom wall and the support being substantially constant in the longitudinal direction, this distance being in particular less than 5 millimetres, especially less than 2 millimetres.

14. Facility for the surface treatment of a substrate (SUB) in motion, comprising
- a support (2) for the substrate,
- a counter-electrode, in particular coincident with the support;
- a treatment assembly placed downstream of the pressing roll, with reference to the travel of the substrate, said assembly comprising at least one treatment unit (1A - 1D) according to any of the preceding claims;
- at least one source of treatment gas and optionally at least one source of auxiliary gas, able to supply the first injection means and optionally the second injection means of each treatment unit.

15. Method for using a surface treatment facility according to the preceding claim, this facility comprising a treatment unit according to any of claims 5 to 13, a method in which the substrate is moved, treatment gas is injected in the direction of this substrate, and auxiliary gas is injected in the direction of this substrate, so as to press at least part of this auxiliary gas in the vicinity of this substrate.
